# EUROPÄISCHE PATENTSCHRIFT

(11) **EP 0 664 585 B1**
(45) Veröffentlichungstag und Bekanntmachung des Hinweises auf die Patenterteilung: **04.03.1998**
(21) Anmeldenummer: 93120733.6
(22) Anmeldetag: 22.12.1993
(51) Int. Cl.: H01S 3/025, G02B 6/42, H01S 3/085, H04B 10/24

(54) **Sende- und Empfangsmodul für eine bidirektionale optische Nachrichten- und Signalübertragung**
Transmitter and receiver module for bi-directional optical communication
Module de transmission et de réception pour système de communication bidirectionnel

(43) Veröffentlichungstag der Anmeldung: 26.07.1995
(73) Patentinhaber: SIEMENS AKTIENGESELLSCHAFT, 80333 München (DE)
(72) Erfinder: Althaus, Hans Ludwig, Dr. rer. nat., D-93138 Lappersdorf (DE); Dietrich, Ralf, D-81543 München (DE); Gramann, Wolfgang, D-93057 Regensburg (DE); Späth, Werner, Dipl.-Phys., D-83607 Holzkirchen (DE)

(56) Entgegenhaltungen:
- EP-A- 0 199 565
- EP-A- 0 243 170
- EP-A- 0 545 905
- WO-A-93/21551
- GB-A- 2 213 957
- US-A- 4 807 238
- PATENT ABSTRACTS OF JAPAN vol. 11, no. 93 (P-559) 24. März 1987 & JP-A-61 243 963 (SONY CORP)

## Beschreibung

Die Erfindung betrifft ein Sende- und Empfangsmodul für eine bidirektionale optische Nachrichten- und Signalübertragung nach dem Oberbegriff des Anspruchs 1.

Derartige Sende- und Empfangsmodule sind bekannt und beispielsweise in der EP-A-D 463 214 beschrieben. Solche Module werden zur bidirektionalen Nachrichten- bzw. Datenübertragung im Vollduplex- oder Halbduplexbetrieb eingesetzt.

Bei einem aus der EP-A-0 238 977 bekannten Sende- und Empfangsmodul für ein bidirektionales optisches Kommunikationsnetz sind im wesentlichen zwischen einer Laserdiode und einem Lichtleitfaserende zwei Kugellinsen im Abstand voneinander angeordnet, die das Laserlicht auf das Faserende fokussieren. Zwischen den Kugellinsen ist eine Lichtstrahltrenneinrichtung bzw. ein Strahlteiler angeordnet, der ein vom Faserende in Richtung der senderfernen Linse divergent abgestrahltes und von dieser Linse gebündeltes Licht mit einer von der Wellenlänge des Laserlichtes verschiedenen Wellenlänge von dem Strahlengang trennt und einem Detektor bzw. Lichtempfänger zuleitet. Um die Dejustageempfindlichkeit eines solchen Moduls zu vermeiden, sind die Laserdiode und die dieser naheliegende Linse auf einem gemeinsamen Trägerkörper relativ zueinander dejustagesicher fixiert. Zumindest die Laserdiode bzw. der Lichtsender, die sendernahe Linse, die Lichtstrahltrenneinrichtung (Strahlteiler) und der Lichtempfänger (Detektor) sind in einem Gehäuse aufgenommen, an das ein Ende einer optischen Faser so anschließbar ist, daß dieses Ende in dem relativ zum gemeinsamen Gehäuse ortsfest definierten Fokus des Lichtes der einen Wellenlänge angeordnet ist. Zum Schutz gegen störende Umwelteinflüsse, insbesondere der im Gehäuse untergebrachten aktiven Halbleiterbauteile (Lichtsender und Lichtempfänger) ist das Gehäuse hermetisch dicht.

Der Erfindung liegt die Aufgabe zugrunde, bei einem Sende- und Empfangsmodul der eingangs genannten Art den Herstellaufwand wesentlich zu reduzieren und das Modul derart auszubilden, daß eine unmittelbar vor dem Laserchip angeordnete Linsenkoppeloptik auf einfache Weise justiert und stabil fixiert werden kann.

Diese Aufgabe wird erfindungsgemäß durch ein Sende- und Empfangsmodul mit den Merkmalen des Anspruchs 1 gelöst.

Vorteilhafte Ausgestaltungen bzw. Weiterbildungen der Erfindung sind Gegenstand zusätzlicher Ansprüche.

US-A-4 807 238 beschreibt ein optoelektronisches Bauelement mit einem Laserchip und einer Linsenkoppeloptik, in dem der Laserchip auf einem Träger zwischen zwei Trägerteilen angeordnet ist. Die dem Laserchip zugewandten Seitenflächen der beiden Trägerteile sind durch einen Ätztvorgang erzeugt worden und gegenüber dem Laserchip geneigt. Desweiteren ist die Linsenkoppeloptik auf einem der beiden Trägerteile befestigt.

Die mit der Erfindung erzielten Vorteile bestehen insbesondere darin, daß das Sende- und Empfangsmodul einen Aufbau besitzt, der unter Nutzung von Komponenten und Techniken der Mikromechanik und Mikrooptik sowohl eine vereinfachte Montage des Laserchips auf einem Subträger (Submount) als auch eine besonders rationelle Herstellung einer Vielzahl derartiger Modul-Subbauteile im Scheibenverband erlaubt. Dabei können gleichzeitig alle mechanischen Verbindungs- und optischen Abbildungselemente sowie die Laserchips montiert und dann vereinzelt und gehäust werden. Das Modul zeichnet sich durch einen raumsparenden Aufbau, eine mechanisch stabile Linsenkoppeloptik und eine definierte Strahlcharakteristik aus.

Das bidirektionale Modul ist als optoelektronisches Sende- und Empfangsbauelement für die optische Signal- bzw. Nachrichten- oder Datenübertragung über lichtleitende optische Fasern wie Lichtleiter aus Kunststoff oder Glas oder sogenannte Multimode- oder Monomodefasern aus Quarz für die optische Nachrichtentechnik besonders vorteilhaft verwendbar.

Anhand von in den Figuren der Zeichnung dargestellten Ausführungsbeispielen wird die Erfindung im folgenden näher erläutert. Es zeigen
- FIG 1: ein bidirektionales Sende- und Empfangsmodul mit im Gehäuse integriertem Lichtempfänger und
- FIG 2: ein bidirektionales Sende- und Empfangsmodul mit im Gehäuse integrierter optischer Kopplung für einen externen Lichtempfänger.

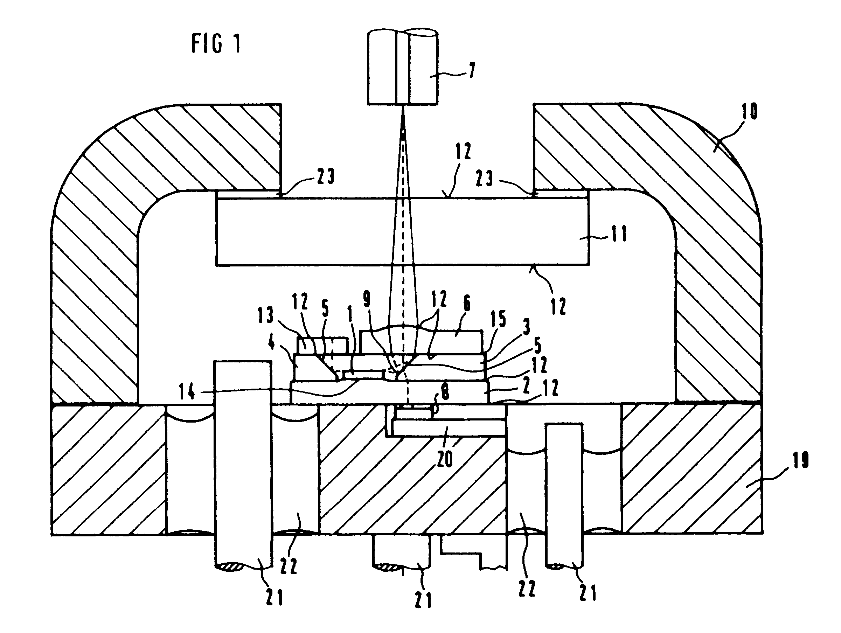

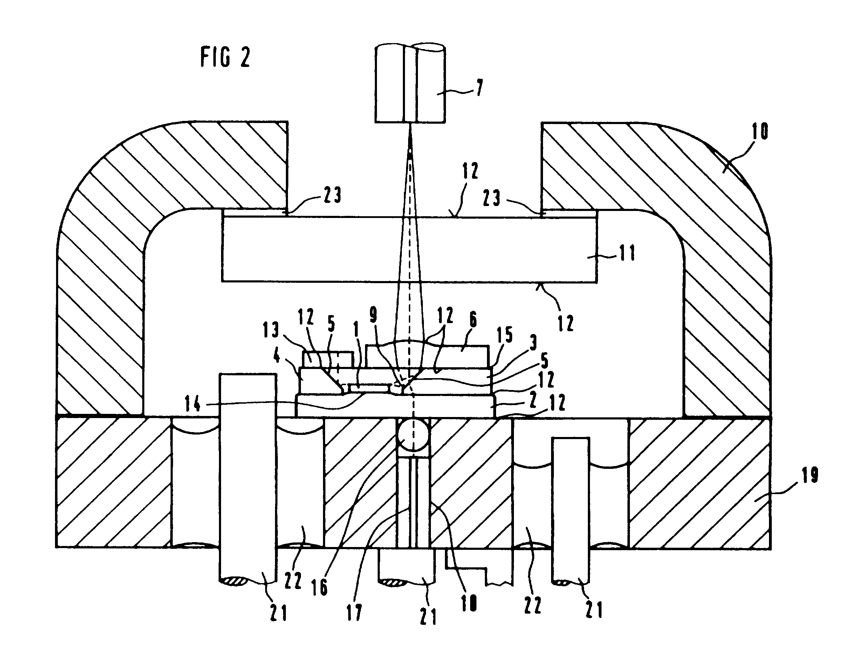

Das in den FIG 1 und 2 schematisch dargestellte bidirektionale Sende- und Empfangsmodul besteht im wesentlichen aus einem eine Linsenkoppeloptik 6 aufweisenden Laserchip 1 als Lichtsender, einem Lichtempfänger 8 und einem im Strahlengang zwischengeordneten Strahlteiler 9, die zumindest teilweise von einem Gehäuse 10 umfaßt sind. An das Modul ist ein externer Lichtwellenleiter 7 optisch ankoppelbar. Die optische Ankopplung erfolgt dabei durch ein Fenster 11 im Gehäuse 10 über die oberhalb des Laserchips 1 angeordnete Linsenkoppeloptik 6. Das Fenster 11 ist mittels einer Glasschicht 23 an das Gehäuse 10 angeglast. Der Laserchip 1 ist auf einem gemeinsamen Träger 2 angeordnet, der vorzugsweise aus Silizium besteht und als Submount beispielsweise auf die Bodenplatte 19 eines TO-Gehäuses montiert werden kann. Der Laserchip 1 ist auf dem gemeinsamen Träger zwischen zwei Trägerteilen 3, 4 angeordnet, deren den optischen Resonatorflächen des Laserchips 1 benachbarte Seitenflächen mit Spiegelschichten 5 versehen und zu den Resonatorflächen in einem Winkel von etwa 45° geneigt sind, so daß die vom Laserchip 1 emittierte kohärente Strahlung als divergentes Lichtbündel zur Oberfläche des gemeinsamen Trägers 2 nahezu senkrecht nach oben auf die oberhalb des Laserchips 1 angeordnete Linsenkoppeloptik 6 umgelenkt wird. Die beiden Trägerteile 3, 4 bestehen vorzugsweise aus Glas oder wie der Träger 2 aus Silizium und weisen ein trapezförmiges Profil auf. Insbesondere zur Vereinfachung der Justage und Befestigung dieser beiden Trägerteile 3, 4 ist es vorteilhaft, in dem gemeinsamen Träger 2 hierzu passende Vertiefungen bzw. Gräben vorzusehen, in die die Trägerteile 3, 4 dann eingefügt und darin befestigt sind. Als Spiegelschichten 5 sind auf den benachbarten Seitenflächen der Trägerteile 3, 4 zweckmäßig Schichten aus dielektrischem Material aufgebracht. Auf mindestens dem einen Trägerteil, in diesen Ausführungsbeispielen auf dem Trägerteil 3, ist die Linsenkoppeloptik 6 so angeordnet und befestigt, daß die vom Laserchip 1 emittierte Strahlung auf diese nahezu senkrecht auftrifft.

Die der Vorderseite des Laserchips 1 benachbarte Spiegelschicht 5 ist mit einem Strahlteiler 9 versehen, der die vom Laserchip 1 emittierte Strahlung reflektiert und die vom Lichtwellenleiter 7 über die Linsenkoppeloptik 6 eingekoppelte Strahlung durchläßt. Unterhalb des Strahlteilers 9 ist auf der Unterseite des gemeinsamen Trägers 2 der Lichtempfänger 8 (FIG 1) oder eine optische Kopplung (FIG 2) für den Lichtempfänger 8 vorgesehen. Die optische Kopplung für den Lichtempfänger 8 umfaßt zweckmäßig einen weiteren Lichtwellenleiter 17 und/oder eine weitere Linsenkoppeloptik 16 und befindet sich gemäß FIG 2 beispielsweise in einer Bohrung 18 in der Bodenplatte 19 des Gehäuses 10.

Der Strahlteiler 9 bildet eine optische Trenneinrichtung für verschiedene oder gleiche Lichtwellenlängen. Für verschiedene Lichtwellenlängen von Sende- und Empfangszweig, d.h. wenn der Strahlteiler wellenlängenselektiv arbeitet, kann eine Trennung von größer als 95 Prozent erreicht werden. Bei gleicher Wellenlänge kann für beide Zweige z.B. eine 50-prozentige oder andere Trennung eingestellt werden.

Um eine bidirektionale Übertragung zu erreichen, braucht nur die der Vorderseite des Laserchips 1 benachbarte Spiegelschicht 5, die auf dem Trägerteil 3 aufgebracht ist, mit einer Filterschicht als Strahlteiler 9 versehen werden, die das Laserlicht einer vom Laser emittierten Wellenlänge reflektiert und das aus der Lichtleitfaser 7 kommende Licht einer anderen Wellenlänge durchläßt. Bei Licht mit einer Wellenlänge größer 1,1µm ist Silizium transparent, und es genügt, auf der Unterseite des gemeinsamen Trägers 2, der vorzugsweise aus Silizium besteht, an der Stelle des Lichtaustritts einen geeigneten Lichtempfänger 8 oder eine geeignete optische Kopplung für einen externen Lichtempfänger 8 anzubringen. Als Lichtempfänger 8 dient zweckmäßig eine Fotodiode, ein Transistor oder ein Foto-IC gegebenenfalls mit integriertem oder diskreten bzw. hybriden Verstärker. Den Lichtempfänger 8 kann man auf dem Träger 2 in eine Aussparung entweder direkt oder auf einem geeigneten Submount 20 aufgebracht montieren. Der Lichtempfänger ist zweckmäßig mit Justiermarken versehen, die zur Justierung des Laserchips 1 über dem Lichtempfänger 8 dienen.

Die Linsenkoppeloptik 6 ist vorzugsweise ein Linsenchip mit integrierter refraktiver und/oder diffraktiver Linse. Dieser Linsenchip bzw. die Linsenkoppeloptik 6 kann auch den Laserchip 1 überspannend auf beiden Trägerteilen 3, 4 justiert und fixiert sein. Der Linsenchip besteht je nach der vom Laserchip 1 emittierten Wellenlänge zweckmäßig aus einem entsprechend durchlässigen Glas oder Halbleitermaterial wie Silizium, Siliziumkarbid oder Galliumphosphid. Der Linsenchip, der als Linsenkoppeloptik 6 einseitig auf nur einem Trägerteil oder beidseitig auf beiden Trägerteilen 3, 4 angeordnet werden kann, wird vorteilhaft mit seiner strukturierten und/oder gekrümmten Seite nach unten, d.h. dieser dem Laserchip 1 zugewandten Seite auf das eine oder auf beide Trägerteile 3, 4 aufgebracht und befestigt. Eine solche Anordnung ist insbesondere toleranzfreundlicher als eine Anordnung mit äußerer Krümmung bzw. Struktur. Als Linsenkoppeloptik 6 kann außer einem Linsenchip mit integrierter Linse beispielsweise auch eine Kugellinse oder Zylinderlinse verwendet werden, die in einer Öffnung in einem Linsenträger befestigt ist, der z.B. aus Silizium besteht.

Eine Vielzahl von beispielsweise im wesentlichen aus dem gemeinsamen Träger 2, dem Laserchip 1, den Trägerteilen 3, 4 und der Linsenkoppeloptik 6 bestehenden Submounts läßt sich besonders rationell in einem Waferverband herstellen. Dabei wird eine vorzugsweise aus Silizium bestehende Scheibe als gemeinsamer Träger 2 mit geeigneten metallischen Strukturen 14 zur Bondung der Laserchips 1 versehen. In diesem Träger 2 werden zweckmäßig parallele Vertiefungen bzw. Gräben beispielsweise von einigen 100µm Breite und Abstand geätzt. Die Grabentiefe kann von einem bis zu einigen 100µm betragen. In diese Vertiefungen oder auf den gemeinsamen Träger 2 direkt werden Trägerteile 3, 4 vorzugsweise in Gestalt von Prismenstreifen mit trapezförmigem Profil, bei dem sich die Verlängerungen der beiden Seitenflächen in einem rechten Winkel schneiden, eingebracht und anodisch oder durch Löttechnik gebondet. Die benachbarten Seitenflächen der Trägerteile 3, 4 sind mit Spiegelschichten 5 versehen. Mit Vorteil werden dielektrische Spiegel aus Schichtfolgen wie SiO₂-TiO₂, SiO₂-Si, Al₂O₃-Si oder Kombinationen dieser Schichtenfolgen oder anderer dielektrischer Schichten angebracht. Die schmalere Oberseite der prismenförmigen Trägerteile 3, 4 kann mit einer lötfähigen Metallschichtstruktur 15 z.B. aus Ti-Pt-Au, Cr-Pt-Au, Ti-Ni-Au, Ti-Pt-AuSn, Ni-Au oder anderen lötfähigen Schichten versehen werden.

Zum Aufbau des Submounts werden nun auf die auf dem gemeinsamen Trägerteil 2 vorgesehenen Metallpads bzw. metallischen Strukturen 14 die Laserchips 1, die auf der dem Träger 2 zugewandten Unterseite je nach Anforderung mit einer Lotschicht aus AuSn, AuGe, AuSi, PbSn oder anderen lötfähigen Schichten von ca. 1µm bis 10µm Dicke versehen sind, in einem definierten Abstand vor den Trägerteilen 3, 4 festgelötet.

Die besondere Ausführung des Lasersubmounts mit reflektierenden prismenförmigen Trägerteilen 3, 4 zur Strahlumlenkung ermöglicht es nun, das in der Halbleitertechnik übliche, bisher bei den bekannten Laser-Kantenstrahlern nicht anwendbare Testen auf einem Standardwaferprober mit nur einem zusätzlichen optischen Meßkopf zur Erfassung der optoelektronischen Größen einzusetzen.

Nach der Messung kann die Scheibe (Wafer) wahlweise in die einzelnen Submounts (Träger 2) aufgetrennt werden, wobei jeder Submount (Träger 2) einen Laserchip 1 und je einen Teil der prismenförmigen Trägerteile 3, 4 vor der Vorder- und Rückseite des Laserchips 1 enthält. Die Aufteilung der Scheibe, vorzugsweise Siliziumscheibe (Träger 2) in einzelne Submounts kann auch bereits vor Montage der Laserchips 1 vorgenommen werden. Die Submounts können dann einzeln weiterverarbeitet werden.

Vor oder nach der Vereinzelung der Submounts wird dann eine Linsenkoppeloptik 6 hier in Gestalt eines Linsenchips, dessen Linse refraktiv und/oder diffraktiv sein kann, aktiv oder passiv, d.h. mit oder ohne Laserbetrieb als Hilfsmittel, über der Spiegelschicht 5 des Trägerteils 3 vor der Vorderseite des Laserchips 1 in x- und y-Richtung justiert und zweckmäßig durch eine Lötung oder Klebung auf der Oberfläche des Trägerteils 3 befestigt. Das notwendige Lot kann z.B. durch Aufdampfen auf den Linsenchip aufgebracht worden sein, das dann zur Fixierung unter Druckkontakt zur Unterlage (Trägerteil 3) aufgeschmolzen wird. Der Wärmewiderstand des Trägerteils 3, beispielsweise Glasprismas, ist so bemessen, daß nur eine unwesentliche Erwärmung des Materials des Trägers, beispielsweise Si-Substrats, beim Lötvorgang erfolgt.

Die Summe der Abstände Vorderseite des Laserchips 1 - Trägerteil 3, Trägerteil 3 - Linsenchip 6 plus optische Dicke der Linse im Linsenchip 6 ergibt die Gegenstandsweite der optischen Abbildung. Wenn jedoch die gekrümmte Fläche des Linsenchips 6 vom Laserchip abgewandt ist, dann ist die optische Dicke der Linse des Linsenchips 6 als ein Teil der Gegenstandsweite zu berücksichtigen. Die Gegenstandsweite der optischen Abbildung kann bei festem Abstand Trägerteil 3 - Linsenchip 6 und fester optischer Dicke der Linse im Linsenchip 6 allein über eine Lateralverschiebung, also Änderung des Abstandes der Vorderseite des Laserchips 1 zum Trägerteil 3 hin oder von diesem weg eingestellt bzw. variiert werden. Die z-Justage ist so auf eine einfache Lateraljustage transformiert worden. Damit läßt sich die Abbildung des Laserflecks sehr einfach auf den Kern einer Lichtleitfaser 7, die sich in einem vorgegebenen Abstand vor der Linse des Linsenchips 6 befindet, einstellen.

Die verwendeten Linsenchips können in einem Scheibenprozeß durch spezielle photolithographische und ätztechnische Prozesse hergestellt werden. Das Linsenmaterial wird je nach den technischen Anforderungen ausgewählt. Für Wellenlängen größer 1,1µm wird mit Vorteil Silizium verwendet, für kürzere Wellenlängen spezielle Gläser oder Halbleitermaterial wie z.B. Galliumphosphid oder Siliziumkarbid. Silizium kann aber auch nur Träger für Linsen sein. Die Verwendung von Silizium ergibt bezüglich Temperaturänderungen einen besonders stabilen Aufbau, da gemeinsamer Träger 2 (Submount), Trägerteile 3, 4 (z.B. Glasprismen) und Linsenkoppeloptik 6 (Linsenchips) in den in Frage kommenden Temperaturintervallen nahezu gleichen Ausdehnungskoeffizienten haben.

Zweckmäßig kann auf der Oberseite des einen Trägerteils 4, das dem Trägerteil 3 gegenüberliegt, das die Linsenkoppeloptik 6 trägt, eine geeignete Monitordiode 13 in der Weise aufgebracht werden, daß ein Teil der Diode über die auf dem Trägerteil 4 aufgebrachte Spiegelschicht 5 hinausragt. Somit können die aus dem hinteren Spiegel (hintere Resonatorseite) des Laserchips 1 austretenden und an der benachbarten Spiegelschicht 5 nach oben reflektierten Photonen (Rückseitenlicht) über das transparente Substrat des Monitorchips 13 den pn-Übergang der Monitordiode erreichen. Bei Monitordioden mit nichttransparentem Substrat wird die Diode mit dem pn-Übergang nach unten auf das Trägerteil 4 aufgebracht. Der Monitorchip 13 kann aber auch über oder auf der Linsenkoppeloptik 6 angeordnet werden, sofern sich beispielsweise ein Linsenchip über beide Trägerteile 3, 4 erstreckt.

Nach optoelektronischer Prüfung können die gemeinsamen Träger 2 (Submounts), auf denen sich Laserchip 1, Trägerteile 3 und 4, Linsenkoppeloptik 6 und Monitorchip 13 befinden, also die Mikromodule, wie ein üblicher Halbleiterchip in Die- und Wirebondtechnik auf einen vorgesehenen Gesamtträger 19, beispielsweise die Bodenplatte eines TO-Gehäuses montiert werden. In der Bodenplatte 19 sind auch die für die optoelektronischen Bauelemente des Moduls notwendigen elektrischen Zuleitungen 21 bzw. Kontakte vorgesehen und darin mittels einer Anglasung 22 befestigt.

Das Sende- und Empfangsmodul hat an den Stellen, an denen das Licht ein- bzw. austritt, eine optische Vergütungsschicht 12 vorzugsweise aus Siliziumnitrid (Si₃N₄). An der Lichteintrittsstelle unter dem prismenförmigen Trägerteil 3 stehen Trägerteil 3 und Vergütungsschicht 12 in einem physikalischen Kontakt (Abstand kleiner ein Zehntel der Wellenlänge), so daß Reflexionsverluste auf der Seite des Trägerteils 3 bzw. auf der zum Lichtempfänger 8 führenden Seite ebenfalls vermieden werden.

Bei einer optischen Strahlung (Licht) mit einer Wellenlänge kleiner 1,1µm kann in den vorzugsweise aus Silizium bestehenden gemeinsamen Träger 2 (Submount) eine Öffnung geätzt werden, so daß das Licht direkt aus dem Trägerteil 3 (Prisma) über Luft auf den Lichtempfänger 8 (z.B. Fotodiode) treffen kann.

Falls es zum Abblocken von Laserlicht, das aus Reflexionen herrühren kann, erforderlich sein sollte, kann auf die Lichteintrittsseite des Lichtempfängers 8 ein geeignetes Filter aufgebracht werden. Das Filter kann aufgeklebt werden. Das Filter kann ein Absorptions- oder Reflexionsfilter sein. Das Filter kann aber auch als Epitaxieschicht oder dielektrisches Filter direkt in die Empfangsdiode ein- bzw. aufgebracht werden.

Bei Halbduplexbetrieb wird der Strahlteiler 9 auf der Spiegelschicht 5 des Trägerteils 3 als 3dB-Teiler ausgebildet, da sich in diesem Fall die Wellenlängen von Laser und Lichtwellenleiter nur geringfügig unterscheiden. Filter über dem Lichtempfänger 8 sind dabei nicht notwendig.

Bei dem in FIG 2 dargestellten Ausführungsbeispiel ist der Lichtempfänger 8 nicht wie in FIG 1 innerhalb des Gehäuses 10, sondern als externes Bauelement außerhalb des Gehäuses 10 vorgesehen. Zu diesem Zweck besitzt das Transceiver-Modul eine optische Kopplung für einen externen Lichtempfänger, die in diesem Ausführungsbeispiel aus einer weiteren Linsenkoppeloptik 16 in Form einer Kugellinse und einem weiteren Lichtwellenleiter 17 besteht, die in eine Bohrung 18 in der Bodenplatte 19 des Modulgehäuses 10 eingelassen und darin befestigt sind.

## Patentansprüche

1. Sende- und Empfangsmodul für eine bidirektionale Nachrichten- und Signalübertragung über einen Lichtwellenleiter mit einer Linsenkoppeloptik, einem Laserchip als Lichtsender, einem Lichtempfänger und einem im Strahlengang zwischengeordneten Strahlteiler, die zumindest teilweise von einem Gehäuse umfaßt sind, **dadurch gekennzeichnet**, daß der Laserchip (1) auf einem gemeinsamen Träger (2) zwischen zwei Trägerteilen (3, 4) angeordnet ist, deren den Resonatorflächen des Laserchips (1) benachbarte Seitenflächen mit Spiegelschichten (5) versehen und zu den Resonatorflächen in einem Winkel von etwa 45° geneigt sind, so daß die vom Laserchip (1) emittierte Strahlung zur Oberfläche des gemeinsamen Trägers (2) nahezu senkrecht nach oben auf die oberhalb des Laserchips (1) angeordnete und an mindestens einem Trägerteil (3, 4) befestigte Linsenkoppeloptik (6) gerichtet ist, daß die der Vorderseite des Laserchips (1) benachbarte Spiegelschicht (5) mit einem Strahlteiler (9) versehen ist, der die vom Laserchip (1) emittierte Strahlung reflektiert und die vom Lichtwellenleiter (7) über die Linsenkoppeloptik (6) eingekoppelte Strahlung durchläßt, und daß unterhalb des Strahlteilers (9) auf der Unterseite des gemeinsamen Trägers (2) der Lichtempfänger (8) oder eine optische Kopplung für den Lichtempfänger (8) vorgesehen ist.

2. Modul nach Anspruch 1, **dadurch gekennzeichnet**, daß die optische Kopplung für den Lichtempfänger (8) einen weiteren Lichtwellenleiter (17) und/oder eine weitere Linsenkoppeloptik (16) umfaßt.

3. Modul nach Anspruch 1 oder 2, **dadurch gekennzeichnet**, daß der gemeinsame Träger (2) aus Silizium besteht.

4. Modul nach einem der Ansprüche 1 bis 3, **dadurch gekennzeichnet**, daß der Strahlteiler (9) eine bestimmte Wellenlänge in einem vorgegebenen Verhältnis aufteilt.

5. Modul nach einem der Ansprüche 1 bis 3, **dadurch gekennzeichnet**, daß der Strahlteiler (9) ein wellenlängenselektiver Strahlteiler ist.

6. Modul nach einem der Ansprüche 1 bis 5, **dadurch gekennzeichnet**, daß die Lichtein- und -austrittsflächen der Modulteile mit einer optischen Vergütung (12) versehen sind.

7. Modul nach einem der Ansprüche 1 bis 6, **dadurch gekennzeichnet**, daß die Trägerteile (3, 4) aus Glas oder aus Silizium bestehen und ein trapezförmiges Profil aufweisen.

8. Modul nach einem der Ansprüche 1 bis 7, **dadurch gekennzeichnet**, daß die Spiegelschichten (5) auf den benachbarten Seitenflächen der Trägerteile (3, 4) Schichten aus dielektrischem Material sind.

9. Modul nach einem der Ansprüche 1 bis 8, **dadurch gekennzeichnet**, daß die Linsenkoppeloptik (6) ein Linsenchip mit integrierter refraktiver und/oder diffraktiver Linse ist.

10. Modul nach Anspruch 9, **dadurch gekennzeichnet**, daß der Linsenchip aus Silizium, Siliziumkarbid, Galliumphosphid oder aus Glas besteht.

11. Modul nach einem der Ansprüche 1 bis 10, **dadurch gekennzeichnet**, daß auf dem einen der beiden Trägerteile (3, 4) oder auf der Linsenkoppeloptik (6) ein Monitor-Chip (13) derart angeordnet und befestigt ist, daß von diesem ein Teil der vom Laserchip (1) erzeugten optischen Strahlung empfangbar ist.

12. Modul nach einem der Ansprüche 1 bis 11, **dadurch gekennzeichnet**, daß der Lichtempfänger (8) eine Fotodiode, ein Fototransistor oder ein Foto-IC mit integriertem oder diskretem Verstärker ist.

## Claims

1. Transmitting and receiving module for bidirectional message and signal transmission via an optical fibre, having lens coupling optics, a laser chip as light transmitter, a light receiver and a beam splitter interposed in the beam path, these being enclosed at least partially by a housing, characterized in that the laser chip (1) is arranged on a common carrier (2) between two carrier parts (3, 4) whose side faces, adjacent to the resonator faces of the laser chip (1), are provided with reflective layers (5) and are inclined at an angle of about 45° to the resonator faces, so that the radiation emitted by the laser chip (1) towards the surface of the common carrier (2) is directed virtually perpendicularly upwards onto the lens coupling optics (6), which are arranged above the laser chip (1) and are fastened to at least one carrier part (3, 4), in that the reflective layer (5) adjacent to the front side of the laser chip (1) is provided with a beam splitter (9) that reflects the radiation emitted by the laser chip (1) and lets through the radiation coupled in from the optical fibre (7) via the lens coupling optics (6), and in that the light receiver (8) or an optical coupling for the light receiver (8) is provided underneath the beam splitter (9), on the underside of the common carrier (2).

2. Module according to Claim 1, characterized in that the optical coupling for the light receiver (8) comprises a further optical fibre (17) and/or further lens coupling optics (16).

3. Module according to Claim 1 or 2, characterized in that the common carrier (2) consists of silicon.

4. Module according to one of Claims 1 to 3, characterized in that the beam splitter (9) splits a specific wavelength in a predefined ratio.

5. Module according to one of Claims 1 to 3, characterized in that the beam-splitter (9) is a wavelength-selective beam-splitter.

6. Module according to one of Claims 1 to 5, characterized in that the light entry and exit faces of the module parts are provided with an optical anti-reflection coating (12).

7. Module according to one of Claims 1 to 6, characterized in that the carrier parts (3, 4) consist of glass or silicon and have a trapezoidal profile.

8. Module according to one of Claims 1 to 7, characterized in that the reflective layers (5) on the adjacent side faces of the carrier parts (3, 4) are layers of dielectric material.

9. Module according to one of Claims 1 to 8, characterized in that the lens coupling optics (6) are a lens chip with an integrated refractive and/or diffractive lens.

10. Module according to Claim 9, characterized in that the lens chip consists of silicon, silicon carbide, gallium phosphide or of glass.

11. Module according to one of Claims 1 to 10, characterized in that a monitor chip (13) is arranged and fastened on one of the two carrier parts (3,4) or on the lens coupling optics (6) in such a way that it can recieve some of the optical radiation produced by the laser chip (1).

12. Module according to one of Claims 1 to 11, characterized in that the light receiver (8) is a photodiode, a phototransistor or a photo IC with an integrated or discrete amplifier.

## Revendications

1. Module de transmission et de réception pour la transmission optique bidirectionnelle d'informations et de signaux sur un guide d'ondes lumineuses avec une optique de couplage à lentille, une puce laser en tant qu'émetteur de lumière, un récepteur de lumière et un diviseur de rayonnement placé sur le parcours des rayons, ces composants étant, au moins partiellement, contenus dans un boîtier,
**caractérisé par le fait**
que la puce laser (1) est placée entre deux pièces de support (3, 4) sur un support commun (2), les faces latérales de ces pièces de support voisines des surfaces de résonance de la puce laser (1) étant munies de couches réfléchissantes (5) et étant inclinées d'un angle d'environ 45° par rapport aux surfaces de résonance, de telle sorte que le rayonnement émis par la puce laser (1) est dirigé vers le haut, presque perpendiculairement à la surface supérieure du support commun (2), sur l'optique de couplage à lentille (6) placée au dessus de la puce laser (1) et fixée au moins à une pièce de support (3, 4),
que la couche réfléchissante (5) voisine de la face avant de la puce laser (1) et munie d'un diviseur de rayonnement (9) qui réfléchit le rayonnement émis par la puce laser (1) et qui laisse passer le rayonnement alimenté par le guide d'ondes lumineuses (7) à travers l'optique de couplage à lentille (6) et
que le récepteur de lumière (8) ou un couplage optique pour le récepteur de lumière (8) est prévu au dessous du diviseur de rayonnement (9) sur la face inférieure du support commun (2).

2. Module selon la revendication 1 **caractérisé par le fait**
que le couplage optique pour le récepteur de lumière (8) comprend un guide d'ondes lumineuses supplémentaire (17) et/ou une optique de couplage à lentille supplémentaire (16).

3. Module selon la revendication 1 ou 2 **caractérisé par le fait**
que le support commun (2) est en silicium.

4. Module selon une des revendications 1 à 3 **caractérisé par le fait**
que le diviseur de rayonnement (9) partage une certaine longueur d'onde suivant un rapport prédéterminé.

5. Module selon une des revendications 1 à 3 **caractérisé par le fait**
que le diviseur de rayonnement (9) est une lame séparatrice sélective au regard de la longueur d'onde.

6. Module selon une des revendications 1 à 5 **caractérisé par le fait**
que les surfaces d'entrée et de sortie de la lumière des éléments du module sont garnies d'une couche optique antireflet (12).

7. Module selon une des revendications 1 à 6 **caractérisé par le fait**
que les pièces de support (3, 4) sont en verre ou en silicium et ont un profil en forme de trapèze.

8. Module selon une des revendications 1 à 7 **caractérisé par le fait**
que les couches réfléchissantes (5) sur les surfaces latérales voisines des pièces de support (3, 4) sont des couches en matière diélectrique.

9. Module selon une des revendications 1 à 8 **caractérisé par le fait**
que l'optique de couplage à lentille (6) est une puce à lentille avec une lentille intégrée réfractive et/ou diffractive.

10. Module selon la revendication 9 **caractérisé par le fait**
que la puce à lentille est en silicium, en carbure de silicium, en phosphure de gallium ou en verre.

11. Module selon une des revendications 1 à 10 **caractérisé par le fait**
qu'une puce monitor (13) est placée et fixée sur une des pièces de support (3, 4) ou sur l'optique de couplage à lentille (6) de telle sorte qu'une partie du rayonnement optique produit par la puce laser (1) peut être reçu par cette puce monitor.

12. Module selon une des revendications 1 à 11 **caractérisé par le fait**
que le récepteur de lumière (8) est une photodiode, un phototransistor ou un photo-IC (ou circuit intégré photoélectrique) avec un amplificateur intégré ou discret.
